# EUROPÄISCHE PATENTSCHRIFT

(11) **EP 2 932 282 B1**
(45) Veröffentlichungstag und Bekanntmachung des Hinweises auf die Patenterteilung: **15.01.2020**
(21) Anmeldenummer: 13814039.7
(22) Anmeldetag: 13.12.2013
(51) Int. Cl.: H02M 1/088, G01R 27/26, G01R 31/12, G01R 31/14, H02M 3/335, H02M 1/00

(54) **SCHALTUNGSANORDNUNG UND VERFAHREN ZUR ERZEUGUNG EINER PRÜFSPANNUNG UND PRÜFGERÄT ZUR ERMITTLUNG EINES VERLUSTFAKTORS, WELCHES DIE SCHALTUNGSANORDNUNG ENTHÄLT**
CIRCUIT ASSEMBLY AND METHOD FOR PRODUCING A TEST VOLTAGE, AND TESTING DEVICE FOR DETERMINING A LOSS FACTOR, WHICH TESTING DEVICE CONTAINS SAID CIRCUIT ASSEMBLY
CIRCUIT ET PROCÉDÉ POUR PRODUIRE UNE TENSION DE CONTRÔLE, ET APPAREIL DE CONTRÔLE POUR LA DÉTERMINATION D'UN FACTEUR DE PERTE, L'APPAREIL CONTENANT LE CIRCUIT

(30) Priorität: 17.12.2012 DE 102012024560
(43) Veröffentlichungstag der Anmeldung: 21.10.2015
(73) Patentinhaber: b2 electronics GmbH, 6833 Klaus (AT)
(72) Erfinder: BLANK, Rudolf, A-6832 Sulz (AT); FURXER, Michael, A-6811 Göfis (AT); BALDAUF, Stefan, A-6830 Rankweil (AT)
(74) Vertreter: Grättinger Möhring von Poschinger Patentanwälte Partnerschaft mbB
(86) Internationale Anmeldenummer: PCT/EP2013/003762
(87) Internationale Veröffentlichungsnummer: WO 2014/095009

(56) Entgegenhaltungen:
- DE-A1- 3 737 373
- DE-A1- 19 513 441
- DE-A1- 19 519 744
- JP-A- S6 365 383
- JP-A- S60 219 965
- US-A1- 2006 006 741
- US-A1- 2009 073 726
- ZHIYU CAO ET AL: "Modeling and Control Design for a Very Low-Frequency High-Voltage Test System", IEEE TRANSACTIONS ON POWER ELECTRONICS, IEEE SERVICE CENTER, PISCATAWAY, NJ, US, Bd. 25, Nr. 4, 1. April 2010 (2010-04-01), Seiten 1068-1077, XP011296135, ISSN: 0885-8993

## Beschreibung

Die vorliegende Erfindung betrifft eine Schaltungsanordnung zur Erzeugung einer Prüfspannung für die Prüfung eines Prüflings umfassend zwei Hochspannungsquellen zur Erzeugung einer positiven und einer negativen Hochspannung variabler Amplitude an ihren jeweiligen Ausgängen, eine zwischen den Ausgängen der zwei Hochspannungsquellen und dem Prüfling angeordnete Hochspannungsschalteranordnung, die zur sukzessiven Auf- und Entladung des Prüflings geeignet schaltbar ist, wobei ferner eine Regelung vorgesehen ist, die die aktuelle Prüfspannung am Prüfling misst und abhängig von der gemessenen Prüfspannung zur definierten Auf- und Entladung des Prüflings auf die Hochspannungsschalteranordnung einwirkt. Ferner betrifft die vorliegende Erfindung ein Prüfgerät zur Ermittlung eines Verlustfaktors, welches die Schaltungsanordnung enthält, und ein Verfahren zur Erzeugung einer Prüfspannung für die Prüfung eines Prüflings unter Verwendung einer solchen Schaltungsanordnung.

Eine derartige Schaltungsanordnung ist z.B. aus der DE 195 13 441 C5 bekannt, wobei dort die zwei Hochspannungsquellen durch zwei Verstärkerzweige gebildet sind, die jeweils ein Schaltnetzteil, einen Hochspannungstransformator und eine Gleichrichterschaltung aufweisen. Jeder Verstärkerzweig ist eingangsseitig mit einer (weiteren) Gleichrichterschaltung verbunden, welche aus einer Netzspannung eine Gleichspannung erzeugt. Eine solche Schaltungsanordnung kann z.B. im Rahmen der so genannten Verlustfaktormessung an Hoch- bzw. Mittelspannungskabeln und anderen elektrischen Bauteilen eingesetzt werden, in deren Rahmen durch Bereitstellung einer im kV-Bereich liegenden und in der Regel sinusförmigen Prüfspannung geringer Frequenz (vorzugsweise im Bereich von 0,01 - 0,1 Hz) an dem betreffenden Prüfling unter Ermittlung und Auswertung der Phasenlage der Prüfspannung und des hierdurch induzierten Prüfstroms der so genannte Verlustfaktor (tan(δ)) des Prüflings bestimmt wird. Mit "Verlust" ist hierbei die Energie gemeint, die elektrisch bzw. elektromagnetisch im Prüfling verloren geht und sich beispielsweise in Wärme umwandelt. Der Verlustfaktor ist ein Maß für diesen Verlust.

Im Folgenden wird zur genaueren Beschreibung des der Verlustfaktormessung zugrunde liegenden Prinzips ein Kondensator betrachtet, der an eine Spannungsquelle mit sinusförmigem Spannungsverlauf angeschlossen ist. Bekannterweise tritt an einem solchen Kondensator eine Phasenverschiebung ϕ zwischen Prüfspannung und dem hierdurch induzierten, die Auf- und Entladung des Kondensators bewirkenden Prüfstrom auf. Ein idealer Kondensator, der keinerlei Verluste aufweist, erzeugt bei sinusförmiger Prüfspannung eine Phasenverschiebung zwischen Spannung und Strom von ϕ=90°. Treten nun im Kondensator Verluste auf, dann beträgt die Phasenverschiebung ϕ zwischen Spannung und Strom nicht mehr exakt 90°, sondern unterscheidet sich von diesem Idealwert um den sogenannten Verlustwinkel δ = (90°-ϕ). Der für einen Prüfling im Rahmen der Verlustfaktormessung zu bestimmende Verlustfaktor wird nun als tan(δ) definiert und erlaubt - bei einer Abweichung von den realistischerweise zu erwartenden Werten - eine Aussage zum Grad einer etwaigen Beschädigung des Prüflings bzw. dahingehend, ob der Prüfling noch für den benötigten Zweck einsetzbar ist.

Für im Boden verlegte Hoch- und Mittelspannungskabel mit einer VPE-Isolierung (VPE=vernetztes Polyehtylen; XLPE= cross linked polyethylen), die z.B. auch Alterungseffekten, wie z.B. dem so genanten "water-tree"-Effekt, ausgesetzt sind, ist zum Beispiel nach den gängigen Prüfkriterien vorgeschrieben, dass deren Verlustfaktor (tan δ) einen Wert von ca. 1 ^{∗} 10⁻³ nicht überschreiten darf bzw. soll (vgl. z.B. Kabelhandbuch, 8. Auflage, Mario Kliesch und Dr. Frank Merschel, Hrsg. Rolf Rüdiger Cichowski, EW Medien und Kongresse GmbH).

Prüfgeräte mit einer Messschaltung zur Verlustfaktormessung bedienen sich dabei in üblicher Weise geeigneter Mittel zur zeitaufgelösten Messung der Prüfspannung und des Prüfstroms sowie einer nachfolgenden mathematischen Auswertung der bei der Messung der Prüfspannung und des Prüfstroms gewonnenen Messdaten, bei der zunächst unter Verwendung einer (diskreten) Fouriertransformation die Wellenlänge von Prüfspannung und Prüfstrom bestimmt und anschließend - unter Einsatz gängiger und geeigneter Approximationsalgorithmen - die mehr oder wenige exakte Phasenlage von Strom- und Spannungskurve und hieraus die jeweilige Phasenverschiebung sowie der Verlustfaktor bestimmt werden. Zur Erreichung einer möglichst hohen bzw. der für den konkreten Anwendungsfall geforderten Messgenauigkeit ist somit die möglichst exakte Bestimmung der Phasenlage von Prüfspannung und Prüfstrom ein entscheidendes Kriterium. Da bei einer sehr geringen Kapazität des Prüflings auch die Amplitude des Prüfstroms entsprechend niedrig ist, ergibt sich für ein zur Verlustfaktormessung eingerichtetes Prüfgerät eine von der Kapazität des Prüflings und der gewählten Prüfspannungsamplitude abhängige Beschränkung des Messbereichs im Hinblick auf die mit vorgegebener Messgenauigkeit zu erfolgende Ermittlung des Verlustfaktors. Diese Messbereichsbeschränkung ist dadurch begründet, dass bei sehr geringen Amplituden des Prüfstroms die exakte Bestimmung von dessen Phasenlage nicht mehr mit der erforderlichen Messgenauigkeit erfolgen kann.

Mit den derzeit aus dem Stand der Technik bekannten Prüfgeräten, welche eine Schaltungsanordnung der eingangs genannten Art mit integrierter Mess- und Auswerteelektronik zur Ermittlung des Verlustfaktors aufweisen, kann der Verlustfaktor (tan δ) eines Prüflings bei Kapazitäten des Prüflings von größer gleich 15 nF unter Verwendung üblicher Messspannungen im Bereich von etwa 3kV bis 20kV (Effektivspannung) mit einer Messgenauigkeit von ca. +/- 1 ^{∗} 10⁻⁴ ermittelt werden, während der Verlustfaktor bei niedrigeren Kapazitäten nicht mehr mit der genannten Genauigkeit ermittelt werden kann.

Zur Erzeugung der vorzugsweise sinusförmigen Prüfspannung niedriger Frequenz im kV-Bereich, die häufig auch im Rahmen einer so genannten VLF(Very Low Frequency)-Kabelprüfung Anwendung findet, gab es im Stand der Technik bereits verschiedene Ansätze.

Bei einer zunächst vorgeschlagenen Variante zur Erzeugung einer Prüfspannung niedriger Frequenz (vgl. S.J. Kearly, R.R. MacKinlay: "Discharge measurements in cables using a solid state 30 kV bipolar low frequency generator", Fifth International Conference on Dielectric Materials, Measurements and Applications, 1988, S. 171-174) wird mittels einer Spannungsquelle eine Gleichspannung von +/- 30 kV bereitgestellt, mit der der zu testende Prüfling unter Einsatz einer als steuerbare Stromquelle ("controllable current source") fungierenden Hochspannungsschalteranordnung definiert auf- und entladen wird. Da dort an den Eingängen der als Kaskadenschaltung ausgebildeten und in Abhängigkeit von der Prüfspannung geregelten Hochspannungsschalteranordnung stets eine Gleichspannung in der Größenordnung von +/- 30 kV anliegt, ist besagte Schaltungsanordnung mit nicht unerheblichen elektrischen Verlusten und einer entsprechenden Wärmeentwicklung verbunden, so dass deren Einsatz in einem möglichst kompakten Prüf- bzw. Diagnosegerät mit integrierter Mess- und Auswerteelektronik zur Verlustfaktormessung nicht bzw. kaum möglich ist.

Eine weitere Schaltungsanordnung zur Erzeugung einer Prüfspannung für die vorliegend relevanten Einsatzzwecke ist, wie dies einleitend bereits erwähnt wurde, aus der DE 195 13 441 C5 bekannt. Dabei wird zum Zwecke der Bereitstellung einer Schaltungsanordnung mit verbessertem Wirkungsgrad und zur Erzeugung von Prüfspannungen verschiedener und vorprogrammierbarer Kurvenformen von der Bereitstellung einer ungeregelten Gleichspannung abgesehen. Stattdessen wird die Prüfspannung im gattungsgemäßen Sinne erzeugt, indem zunächst mittels einer (an dem externen Stromnetz anzuschließenden) Gleichrichterschaltung aus der Netzspannung eine Gleichspannung (veränderlicher Amplitude) erzeugt wird, welche sodann - in zwei als Hochspannungsquellen fungierenden Verstärkerzweigen mit je einem Schaltnetzteil, einem Hochspannungstransformator und einer weiteren Gleichrichterschaltung - in jeweils eine Hochspannung veränderbarer Amplitude transformiert wird, mit denen der Prüfling - über einen in Abhängigkeit von der Spannung am Prüfling regelbaren elektronischen Hochspannungsschalter bzw. eine Hochspannungsschalteranordnung - definiert auf- und entladen werden kann. Dabei dient der erste Verstärkerzweig zur Bereitstellung einer Hochspannung positiven Vorzeichens an dessen Ausgang, während am Ausgang des zweiten Verstärkerzweigs eine Hochspannung negativen Vorzeichens erzeugt wird.

Neben den vorstehend genannten und auch für die vorliegende Erfindung gattungsgemäßen Merkmalen ist dabei ferner vorgesehen, dass mittels der auf den Hochspannungsschalter bzw. die Hochspannungsschalteranordnung einwirkenden Regelung gleichzeitig auch in Abhängigkeit von der am Prüfling mittels eines Spannungsteilers gemessenen (Prüf-)Spannung auf die beiden Schaltnetzteile eingewirkt wird, so dass die gewissermaßen als Hüllkurve für die eigentliche Prüfspannung fungierende Hochspannung an den Ausgängen der beiden Verstärkerzweige (bzw. Hochspannungsquellen) zum Zwecke der Minimierung der Verlustleistung und/oder der erwünschten Einstellung verschiedener Kurvenformen in Abhängigkeit von der Prüfspannung variiert wird. Mit dieser Schaltungsanordnung konnte die Verlustleistung gegenüber dem weiter oben erläuterten Stand der Technik deutlich reduziert werden, was den Einsatz gattungsgemäßer Schaltungsanordnungen in kompakten Prüfgeräten mit integrierter Verlustfaktorermittlung erlaubt. Wie dies weiter unten jedoch noch näher erläutert wird und erst im Rahmen der vorliegenden Erfindung herausgefunden wurde, erzeugt die gemäß der DE 195 13 441 C5 vorgesehene Einwirkung auf die Schaltnetzteile allerdings unerwünschte Oberwellen in der Prüfspannung und insbesondere dem Prüfstrom, die bei einem zur Verlustfaktormessung eingerichteten Prüfgerät eine (deutliche und gegenüber den sonstigen Störquellen eines solchen Geräts nicht unerhebliche) Einschränkung der Messgenauigkeit bewirken.

Weitere Schaltungsanordnungen und Verfahren zur Erzeugung einer Prüfspannung bzw. hiermit ausgestatte Prüfgeräte sind aus der undatierten Firmenschrift "Mobile Testing & Diagnosics: frida with TD, PD-Portable", Sulz, Österreich, S. 1 - 37 der Baur Prüf- und Messtechnik GmbH sowie dem auf den 15. März 2013 datierten Datenblatt "Baur Hochspannungsprüf- und Diagnosegerät - frida, frida TD", Sulz, Österreich, S. 1 - 2 der Baur Prüf- und Messtechnik bekannt. Ferner beschreibt der Artikel CAO, Zhiyu [et al.]:"Modeling and Control Design for a Very-Low-Frequency High-Voltage Test System", IEEE transactions on power electronics, Vol. 25, Nr. 4, April 2010, S. 1068 - 1077 ebenfalls eine gattungsgemäße Schaltungsanordnung und ein Verfahren zur Erzeugung einer VLF-Prüfspannung, wobei dort der ausgangsseitig an der Schaltungsanordnung zu erzeugende Prüfstrom unter Rückregelung auf die Frequenz ("frequency f") und des Tastverhältnisses ("duty cyle d") eines Pulsgenerators eingestellt wird, welcher seinerseits auf die die Prüfspannung erzeugenden Hochspannungsquellen ("Power Supply Block") einwirkt.

Vor diesem Hintergrund ist es die Aufgabe der vorliegenden Erfindung eine Schaltungsanordnung sowie ein Verfahren zur Erzeugung einer Prüfspannung der eingangs genannten Art dahingehend weiterzubilden, dass sich diese zur Erzeugung einer möglichst störungsarmen Prüfspannung und eines möglichst störungsarmen Prüfstroms und zur Verwendung in einem möglichst kompakten Prüfgerät mit hochpräziser Verlustfaktormessung eignen.

Die erfindungsgemäße Schaltungsanordnung zeichnet sich dabei neben den einleitend genannten Merkmalen dadurch aus, dass die erfindungsgemäß vorgesehene Regelung nicht auf die beiden Hochspannungsquellen einwirkt und dass eine separate Steuerung für die beiden Hochspannungsquellen vorgesehen ist, wobei besagte Steuerung ein von der Spannung am Prüfling unabhängiges Taktsignal erzeugt, so dass von den Hochspannungsquellen eine synchronisierte, vordefinierte und nicht durch die Regelung beeinflusste Wechselspannung bereitgestellt wird.

In vorteilhafter Ausgestaltung der Erfindung kann dabei vorgesehen sein, dass die zwei Hochspannungsquellen durch zwei Verstärkerzweige gebildet sind, die jeweils ein Schaltnetzteil, einen Hochspannungstransformator und eine Gleichrichterschaltung aufweisen, wobei jeder Verstärkerzweig eingangsseitig mit einer Gleichrichterschaltung verbunden ist, welche aus einer Netzspannung eine Gleichspannung erzeugt.

Mit anderen Worten ist bei der vorliegenden Erfindung also vorgesehen, dass die von den beiden Hochspannungsquellen (bzw. die von den Schaltnetzteilen der beiden Verstärkerzweige bereitgestellte und nachfolgend verstärkte) Spannung vollkommen unabhängig von der am Prüfling anliegenden Prüfspannung gesteuert wird. Statt einer auf die Hochspannungsquellen bzw. auf darin vorgesehene Schaltnetzteile einwirkenden Regelung wird zur möglichst präzisen Ansteuerung der beiden Hochspannungsquellen bzw. Schaltnetzteile erfindungsgemäß ein von der Steuerung erzeugtes Taktsignal verwendet, mit dessen Hilfe die beiden Hochspannungsquellen eine anhand des Taktsignals synchronisierte und (in ihrer Kurvenform und Phasenlage) exakt vordefinierte Hochspannung variabler Amplitude bereitstellen können.

Im Rahmen der vorliegenden Erfindung wurde bemerkt, dass die im Stand der Technik vorgesehenen Regelungseingriffe auf die Schaltnetzteile unerwünschte Störungen (in Art von Oberwellen im Frequenzspektrum) in der von dem jeweiligen Schaltnetzteil bereitgestellten Wechselspannung bewirken, die in dem betreffenden Verstärkerzweig nachfolgend sogar noch verstärkt werden. Im Ergebnis entstehen dabei unerwünschte Oberwellenanteile in der Prüfspannung, die wiederum entsprechende Störungen in Form eines Rauschens im Prüfstrom verursachen. Dieses Rauschen im Prüfstrom beeinträchtigt die zu einer hochpräzisen Verlustfaktormessung erforderliche Genauigkeit bei der Bestimmung der Phasenlage des Prüfstroms, was sich insbesondere bei der Verlustfaktormessung an Prüflingen mit sehr niedrigen Kapazitäten (und entsprechend niedrigen Prüfströmen) bemerkbar macht.

Demgegenüber kann mit der vorliegenden Erfindung die Entstehung der vorstehend genannten Oberwellen in der Prüfspannung und insbesondere auch im Prüfstrom vermieden werden, womit deren Phasenlage, insbesondere bei Erzeugung von möglichst exakt sinusförmigen Spannungs- und Stromkurven, und damit auch der Verlustfaktor mit besserer Messgenauigkeit bestimmbar ist, was sich insbesondere bei Prüflingen mit geringer Kapazität und entsprechend niedrigen Prüfstromamplituden bemerkbar macht.

Im Rahmen einer Weiterbildung der vorliegenden Erfindung ist in besonders zweckmäßiger Weise vorgesehen, dass die Schaltnetzteile zur Erzeugung einer sinusförmigen Wechselspannung eingerichtet sind, wobei der Phasenwinkel der sinusförmigen Wechselspannung durch das Taktsignal vorgegeben wird. Damit kann dann an dem jeweiligen Ausgang der beiden Verstärkerzweige die positive bzw. negative Halbwelle einer besonders exakt sinusförmigen Wechselspannung bereitgestellt werden.

Weiterhin kann in bevorzugter Weiterbildung der Erfindung dann vorgesehen sein, dass (durch geeignete Ausgestaltung bzw. Programmierung der Regelung) die Prüfspannung und der sich hieraus ergebende Prüfstrom, mit welchem die definierte Auf- und Entladung des Prüflings erfolgt, ebenfalls sinusförmig und, besonders bevorzugt, jeweils nahezu oberwellenfrei sind. Dies erlaubt in einer späteren Auswertung von Messdaten (z.B. im Rahmen der Ermittlung des Verlustfaktors eines Prüflings) eine besonders exakte Bestimmung der jeweiligen Phasenlage von Prüfspannung und Prüfstrom und erhöht damit letztlich die Messgenauigkeit einer der erfindungsgemäßen Schaltungsanordnung nachgeschalteten Mess- und Auswerteelektronik zur Ermittlung des Verlustfaktors eines Prüflings.

Der Oberwellenanteil im Verhältnis zur Grundwelle kann mathematisch in Form der so genannten "gesamten harmonischen Verzerrung" (engl.: "total harmonic distortion") angegeben werden, die das Verhältnis der summierten Quadrate der Effektiv-Amplituden aller Oberschwingungen zum (Effektiv-)Amplitudenquadrat der Grundschwingung repräsentiert. Gezielte Messungen zum Oberwellenanteil der erfindungsgemäß realisierbaren Prüfspannungen und Prüfströme haben ergeben, dass bei Verwendung einer erfindungsgemäßen Schaltungsanordnung nahezu oberwellenfreie Prüfspannungen mit THD-Werten kleiner gleich 0,1% und nahezu oberwellenfreie Prüfströme mit THD-Werten kleiner gleich 5% erzielbar sind. Im Vergleich zu der aus dem Stand der Technik bekannten Schaltungsanordnung mit dort vorgesehenen Regelungseingriffen auf die Schaltnetzteile konnte damit - bei ansonsten identischen Geräten - der Oberwellanteil in der Prüfspannung nahezu gezehntelt (also um einen Faktor 10 verbessert) und der Oberwellenanteil im Prüfstrom nahezu halbiert werden.

Die vorliegende Erfindung betrifft vor diesem Hintergrund nicht nur eine Schaltungsanordnung der vorstehend beschriebenen Art, sondern in vorteilhafter Weise auch ein Prüfgerät, welches eine erfindungsgemäße Schaltungsanordnung, einen Anschluss für die Netzspannung und einen Anschluss für den Prüfling enthält, wobei das erfindungsgemäße Prüfgerät ferner dadurch gekennzeichnet ist, dass es eine integrierte Mess- und Auswerteelektronik zur Ermittlung des Verlustfaktors (sog. Tangens-Delta-Messung) aufweist.

Die mittels einer erfindungsgemäßen Schaltungsanordnung ohne Regelungseingriff auf die Schaltnetzteile erfolgende Erzeugung der Prüfspannung erhöht nicht nur die Messgenauigkeit eines solchen Prüfgeräts im Vergleich zum Stand der Technik, sondern erweitert gleichzeitig auch den - mit vorgegebener Messgenauigkeit abdeckbaren - Messbereich.

Während die aus dem Stand der Technik bekannten Schaltungsanordnungen (mit Regelung auf die beiden Schaltnetzteile) zum Einbau in kompakte Prüfgeräte der vorstehend beschriebenen Art bei der Ermittlung des Verlustfaktors eine Messgenauigkeit von +/- 1 ^{∗} 10⁻⁴ in der Regel nur für kapazitive Lasten von größer gleich 10 - 15 nF einhalten, kann im Rahmen der vorliegenden Erfindung bei ansonsten identischem Prüfgerät dessen Messbereich erweitert werden, indem die gleiche Messgenauigkeit bei Kapazitäten von größer gleich 2 nF bzw. sogar von größer gleich 1 nF eingehalten werden, und zwar über einen (üblichen) Prüfspannungsbereich von 3 kV bis 20 kV.

Dies ist insbesondere deshalb von Bedeutung, da die mit erfindungsgemäßen Schaltungsanordnungen typischerweise zu vermessenden Mittelspannungs- bzw. Hochspannungskabel Kapazitäten von ca. 0,2 nF pro Meter Kabellänge aufweisen. Mit einem erfindungsgemäßen Prüfgerät sind somit bereits Hochspannungskabel mit einer Länge ab ca. 10 Metern vermessbar, während bei Verwendung der aus dem Stand der Technik bekannten Schaltungsanordnung lediglich Kabel ab einer Mindestlänge von 50 Metern mit der erforderlichen Genauigkeit vermessbar waren.

An dieser Stelle sei erwähnt, dass entsprechende oder sogar bessere Messgenauigkeiten im Rahmen der Verlustfaktormessung auch bereits mit anderen Arten von Prüfgeräten erzielbar sind, bei denen jedoch stets ein (VLF-) Prüfspannungsgenerator und ein externes, zusätzliches Messgerät zur Ermittlung des Verlustfaktors mit darin integrierten Mitteln zur hochpräzisen Messung des Prüfstroms und der Prüfspannung zum Einsatz kommen.

Bei einem erfindungsgemäßen Prüfgerät mit erfindungsgemäßer Schaltungsanordnung und integrierter Mess- und Auswertelektronik zur Verlustfaktormessung muss jedoch - im Unterschied zu externen Messgeräten zur Bestimmung des Verlustfaktors - der zu messende Strom über eine Schutzerdeverbindung bzw. über eine Guard-Verbindung, also ein elektronisch erzeugtes Schutzerde-Potential an einer zusätzlichen Messleitung, geführt werden, was im Vergleich zu von der Prüfspannungsquelle getrennten Verlustfaktormessgeräten unausweichlich zu dort nicht vorhandenen Störungen bzw. Oberwellen im Prüfstrom führt, die im Stand der Technik zu den durch den Regelungseingriff auf die Schaltnetzteile erzeugten Störungen hinzu kam und deren Messgenauigkeit im bereits erläuterten Sinn beeinträchtigt hatte.

Durch Verwendung der erfindungsgemäßen Schaltungsanordnung in einem Prüfgerät mit integrierter Tangens-Delta-Messung kann nun bei solchen Prüfgeräten erstmals die vorstehend erläuterte Messgenauigkeit eingehalten werden.

Und schließlich betrifft die vorliegende Erfindung noch ein Verfahren zur Erzeugung einer Prüfspannung für die Prüfung eines Prüflings umfassend die folgenden Schritte:
(A) Erzeugung einer ersten Hochspannung mit positivem Vorzeichen und variabler Amplitude am Ausgang einer ersten Hochspannungsquelle und einer zweiten Hochspannung mit negativem Vorzeichen und variabler Amplitude am Ausgang einer zweiten Hochspannungsquelle
(B) Sukzessives Auf- und Entladen des Prüflings durch geeignete Schaltung einer zwischen den Ausgängen der Hochspannungsquellen und dem Prüfling angeordneten Hochspannungsschalteranordnung, wobei eine Regelung vorgesehen ist, die die Spannung am Prüfling misst und abhängig von der gemessenen Spannung zur definierten Auf- und Entladung des Prüflings auf die Hochspannungsschalteranordnung einwirkt.

Dabei ist erfindungsgemäß vorgesehen, dass die Regelung nicht auf die beiden Hochspannungsquellen einwirkt und dass eine separate Steuerung auf die beiden Hochspannungsquellen einwirkt, wobei die Steuerung ein von der Spannung am Prüfling unabhängiges Taktsignal erzeugt, so dass von den Hochspannungsquellen eine synchronisierte, vordefinierte und nicht durch die Regelung beeinflusste Hochspannung bereitgestellt wird.

Für das erfindungsgemäße Verfahren, welches im Rahmen der Erfindung vorteilhaft noch um einen weiteren Verfahrensschritt zur Ermittlung des Verlustfaktors (in der weiter oben beschriebenen Art und Weise) des Prüflings ergänzt werden kann, gelten ersichtlich die gleichen Vorteile und bevorzugten Ausgestaltungen, wie diese bereits in Zusammenhang mit der erfindungsgemäßen Schaltungsanordnung und dem erfindungsgemäßen Prüfgerät beschrieben wurden, so dass insoweit auf die vorstehenden Ausführungen verwiesen wird.

Nachfolgend sind verschiedene Ausführungsbeispiele der vorliegenden Erfindung anhand der Zeichnung näher erläutert. Dabei zeigt:
- Fig. 1: eine Schaltskizze zu einem ersten Ausführungsbeispiel einer erfindungsgemäßen Schaltungsanordnung,
- Fig. 2: eine Schaltskizze zu einem zweiten Ausführungsbeispiel einer erfindungsgemäßen Schaltungsanordnung,
- Fig. 3a und 3b: eine schematische Darstellung zur Erzeugung von Prüfspannung und Prüfstrom gemäß dem Stand der Technik und der vorliegenden Erfindung,
- Fig. 4a und 4b: Messergebnisse zum Verlauf der Prüfungsspannung und des Prüfstroms unter Verwendung einer aus dem Stand der Technik bekannten Schaltungsanordnung,
- Fig. 5a und 5b: Messergebnisse zum Verlauf der Prüfungsspannung und des Prüfstroms unter Verwendung einer erfindungsgemäßen Schaltungsanordnung und
- Fig. 6: eine schematische Ansicht eines Ausführungsbeispiels eines erfindungsgemäßen Prüfgeräts.

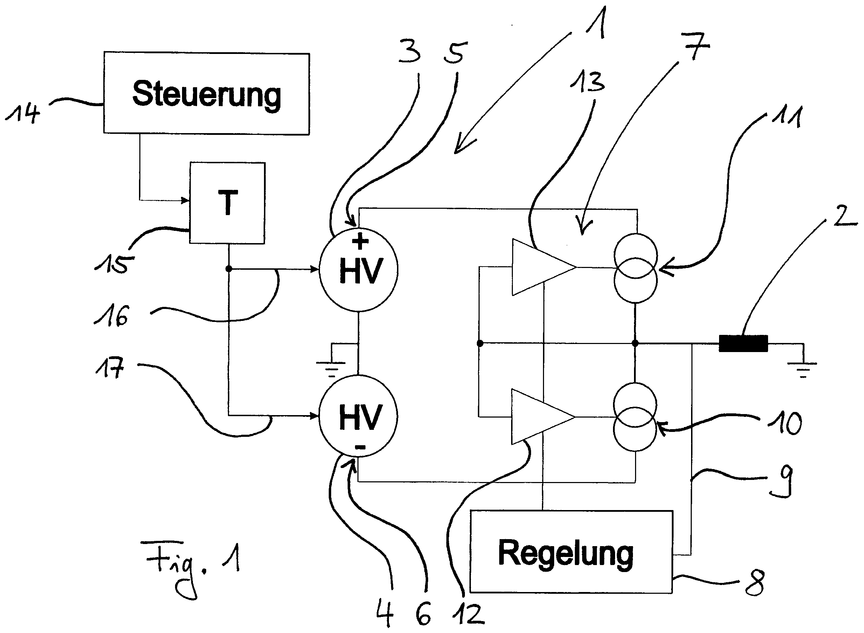

Die in Fig. 1 dargestellte Schaltskizze zeigt ein erstes Ausführungsbeispiel einer erfindungsgemäßen Schaltungsanordnung 1 zur Erzeugung einer Prüfspannung für die Prüfung eines an der Schaltungsanordnung 1 anzuschließenden Prüflings 2, hier eines schematisch dargestellten Hoch- bzw. Mittelspannungskabels. Die Schaltungsanordnung 1 umfasst zwei Hochspannungsquellen 3, 4, welche dazu eingerichtet sind, an ihren jeweiligen Ausgängen 5, 6 eine positive (+) bzw. negative (-) Hochspannung variabler Amplitude bereitzustellen. Zwischen den Ausgängen 5, 6 der beiden Hochspannungsquellen 3, 4 und dem an die Schaltungsanordnung 1 anzuschließenden Prüfling 2 ist eine Hochspannungsschalteranordnung 7 vorgesehen, auf welche mittels einer Regelung 8 zur definierten Auf- und Entladung des eine gewisse kapazitive Last darstellenden Prüflings 2 eingewirkt wird. Die Regelung 8 ist über die Leitung 9 mit dem am Prüfling 2 anliegenden Spannungspotential verbunden und dazu eingerichtet, die dort anliegende Prüfspannung zu messen, um diese im Rahmen der Regelung des gewünschten und von der Regelung 8 vorzugebenden Spannungsverlaufs, welcher vorzugsweise sinusförmig ist, zu berücksichtigen. Die Prüfspannung kann ersichtlich nur innerhalb des durch die beiden Hochspannungsquellen 3, 4 vorgegebenen Spannungsbereichs liegen, wobei die durch die beiden Hochspannungsquellen 3, 4 vorteilhaft sinusförmig vorgegebene Hochspannung vorzugsweise stets etwas höher liegt als die über die Hochspannungsschalteranordnung 7 hiervon abgegriffene Prüfspannung, um etwas Spielraum zum Ausgleich von - z.B. durch Regelungseingriffe verursachten - Lastwechseln zu haben.

Die Hochspannungsschalteranordnung 7 umfasst vorliegend zwei z.B. Halbleiterschalterkaskaden 10, 11, die in Entsprechung des gewählten Schaltzeichens als spannungsgesteuerte Stromquellen fungieren und über je einen Verstärker 12, 13, auf welchen die Regelung 8 einwirkt, rückgekoppelt sind, wie dies auch in der bereits weiter oben zitierten Veröffentlichung (S.J. Kearly, R.R. MacKinlay: "Discharge measurements in cables using a solid state 30 kV bipolar low frequency generator", Fifth International Conference on Dielectric Materials, Measurements and Applications, 1988, S. 171-174) näher erläutert ist. Derartige, als (spannungs-)gesteuerte Stromquellen fungierende Halbleiterschalteranordnungen (z.B. auf Transistor- bzw. FET-Basis) sind aus dem Stand der Technik hinlänglich bekannt (vgl. z.B. U. Tietze, Ch. Schenk, Halbleiter-Schaltungstechnik, 12. Auflage, Kapitel 12.3, Springer-Verlag).

Die beiden Hochspannungsquellen 3, 4 werden nicht durch die Regelung 8, sondern von einer separaten Steuerung 14 angesteuert, wobei die Steuerung 14 einen Taktsignalgeber 15 umfasst, der über die Leitungen 16, 17 den beiden steuerbaren Hochspannungsquellen 3, 4 ein Taktsignal T zuführt, welches bei der Hochspannungserzeugung derart berücksichtigt wird, dass die zwei Hochspannungsquellen 3, 4 jeweils eine anhand des Taktsignals T synchronisierte, in Kurvenform und Amplitude definiert vorgebbare, vorteilhaft kantenfreie und insbesondere sinusförmige, und nicht durch die Regelung 8 beeinflusste Hochspannung bereitstellen können.

Der hierfür benötigte Taktgeber 15 kann beispielsweise digital auf Quarzbasis oder mechanisch in Art eines Schrittmotors realisiert sein und sollte zur Erzeugung eines hinreichend präzisen Taktsignals T, z.B. mit Wiederholraten im *µ*s-Bereich, eingerichtet sein.

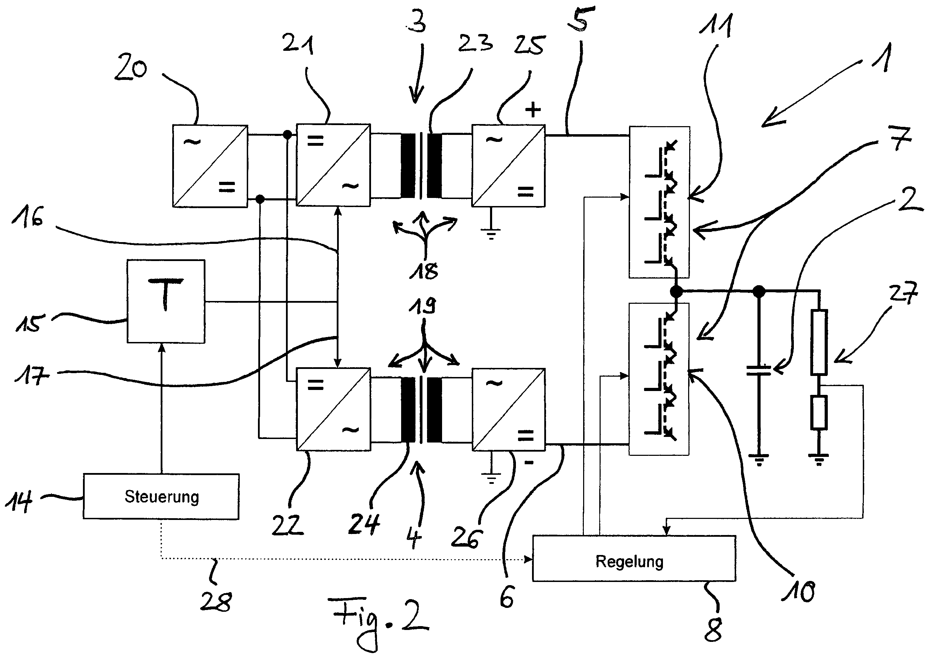

Fig. 2 zeigt ein zweites Ausführungsbeispiel einer erfindungsgemäßen Schaltungsanordnung zur Erzeugung einer Prüfspannung für die Prüfung eines an der Schaltungsanordnung 1 anzuschließenden Prüflings 2 mit kapazitiven Eigenschaften, wobei zum Zwecke der vereinfachten Erläuterung der vorliegenden Erfindung funktions- bzw. baugleiche Bestandteile der Schaltungsanordnung aus Fig. 2 mit denselben Bezugszeichen wie in der Schaltungsanordnung aus Fig. 1 bezeichnet wurden, zu deren Beschreibung somit auf die vorstehenden Ausführungen verwiesen werden darf.

Die Besonderheit der Schaltungsanordnung aus Fig. 2 liegt darin, dass hier die beiden Hochspannungsquellen 3, 4 durch je einen Verstärkerzweig 18, 19 gebildet sind, wobei jeder Verstärkerzweig 18, 19 eingangsseitig an eine Gleichrichterschaltung 20 angeschlossen ist, die aus einer Netzspannung eine Gleichspannung (variabler Amplitude) erzeugt. Jeder Verstärkerzweig 18, 19 umfasst ein (eingangsseitig angeordnetes) Schaltnetzteil 21, 22 zur Erzeugung einer vorgebbaren, insbesondere sinusförmigen, Wechselspannung, einen Hochspannungstransformator 23, 24 zur Verstärkung der von dem jeweiligen Schaltnetzteil 21, 22 erzeugten Wechselspannung und eine (ausgangsseitig angeordnete) Gleichrichterschaltung 23, 24, mit welcher sichergestellt wird, dass am Ausgang 5 des ersten Verstärkerzweigs 18 stets eine Hochspannung positiven Vorzeichens und am Ausgang 6 des zweiten Verstärkerzweigs 19 stets eine Hochspannung negativen Vorzeichens bereitgestellt wird.

Die Schaltskizze des zweiten Ausführungsbeispiels einer erfindungsgemäßen Schaltungsanordnung 1 gemäß Fig. 2 zeigt ferner, dass die zwischen der Ausgängen 5, 6 der beiden als Hochspannungsquellen 3, 4 fungierenden Verstärkerzweige 18, 19 und dem Prüfling 2 angeordnete Hochspannungsschalteranordnung 7 durch zwei Halbleiterschalterkaskaden 10, 11, auf welche die Regelung 8 geeignet einwirkt, ausgestaltet sein können. Ferner wird bei dem Ausführungsbeispiel aus Fig. 2 die am Prüfling 2 anliegende und von der Regelung 8 mittels einer geeigneten Messeinrichtung gemessene Prüfspannung über einen Spannungsteiler 27 abgegriffen.

Und schließlich ist bei dem Ausführungsbeispiel gemäß Fig. 2 durch den gestrichelt dargestellten Pfeil 28 angedeutet, dass von der Steuerung 14 ggfs. auch Informationen (z.B. über das von der Steuerung 14 bzw. dem Taktsignalgeber 15 erzeugte Taktsignal T) an die Regelung 8 (jedoch nicht umgekehrt) übermittelt werden können, was dann ggfs. bei der Einwirkung auf die Hochspannungsschalteranordnung 7 berücksichtigt werden kann.

Da die in den beiden Hochspannungsquellen 3, 4 bzw. mittels der Schaltnetzteile 21, 22 unter anschließender Hochspannungsverstärkung erzeugte Hochspannung in ihrer zeitlichen Variation vorliegend durch die Steuerung 14 und das von dieser erzeugte Taktsignal T gesteuert wird und die Hochspannungserzeugung ohne sonstige Regelungseingriffe von statten geht, lässt sich mit den Hochspannungsquellen 3, 4 der erfindungsgemäßen Schaltungsanordnung 1 insbesondere ein besonders "glatter", d.h. kantenfreier (und vorteilhaft sinusförmiger) Verlauf des jeweiligen Spannungsprofils erzeugen.

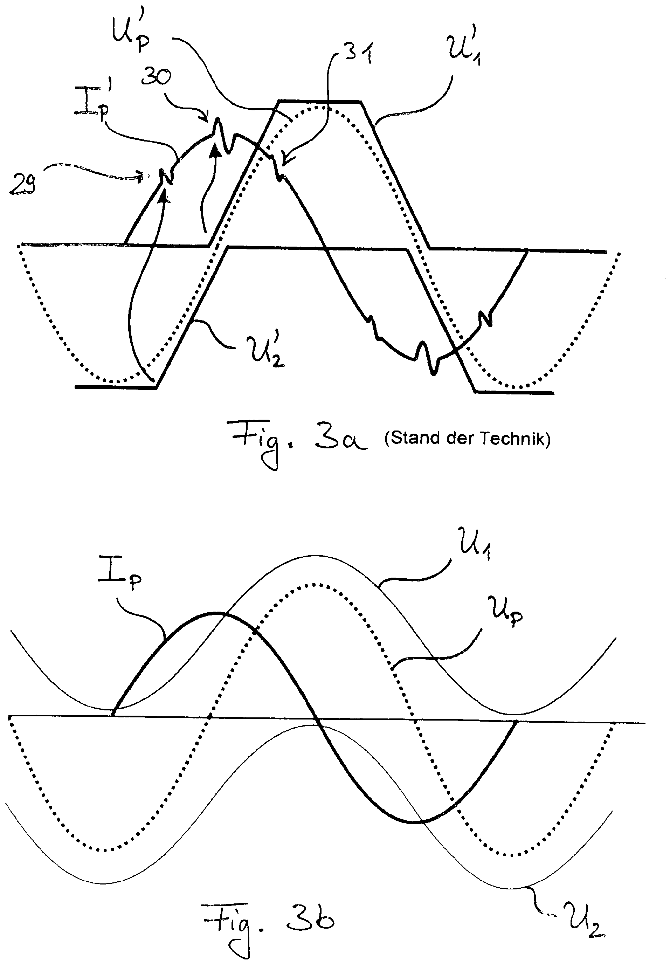

Die schematischen Spannungs- und Stromkurven aus den Fig. 3a und 3b verdeutlichen den mit der vorliegenden Erfindung erzielbaren Effekt.

Die schematische Darstellung aus Fig. 3a veranschaulicht die mit einer aus dem Stand der Technik bekannten Schaltungsanordnung mit Regelungseingriffen auf die Hochspannungsquellen erzeugten Spannungs- und Stromverläufe, bei denen die am Ausgang zweier Verstärkerzweige bereitgestellten Hochspannungen U₁', U₂' durch einen Kanten aufweisenden Spannungsverlauf mit Regelungseingriffen gekennzeichnet sind. Aus diesen beiden Hochspannungen U₁', U₂', die gewissermaßen eine Hüllkurve für die Prüfspannung U_{P}' bilden, lässt sich mittels geeigneter Regelung der hochspannungsseitigen Halbleiterschalteranordnung ein weitgehend sinusförmiger Verlauf der Prüfspannung U_{P}' erzeugen. Die in den Spannungshüllkurven vorhandenen Kanten und die hiermit verbundenen Lastwechsel in der Schaltungsanordnung verursachen jedoch, wie auch sonstige Regelungseingriffe auf die Hochspannungsquellen, in dem idealerweise sinusförmigen Prüfstrom I_{P}' die in Fig. 3a schematisch dargestellten Störungen 29, 30, 31 in Art von Oberwellen bzw. Rauschen, was letztlich die Genauigkeit einer in einem späteren Messvorgang ggfs. erforderlich werdenden Ermittlung der exakten Phasenlage des Prüfstroms I_{P}', insbesondere bei sehr geringen Stromamplituden, nachteilig beeinflusst.

Demgegenüber können im Rahmen der vorliegenden Erfindung, wie dies in Fig. 3b schematisch dargestellt ist, unter Nutzung einer erfindungsgemäßen Schaltungsanordnung mittels der beiden durch ein Taktsignal der Steuerung synchronisierten und nicht von Regelungseingriffen belasteten Hochspannungsquellen besonders exakt sinusförmige und kantenfreie Hochspannungen U₁, U₂ erzeugt werden, aus denen mittels der Hochspannungsschalteranordnung eine ebenfalls besonders exakt sinusförmige und nahezu oberwellenfreie Prüfspannung U_{P} - sowie hieraus folgend - ein nahezu oberwellenfreier Prüfstrom I_{P} erzeugt werden, was die Messgenauigkeit eines eine solche Schaltungsanordnung aufweisenden Messgeräts mit integrierter Verlustfaktormessung deutlich erhöht, wie dies bereits weiter oben erläutert wurde.

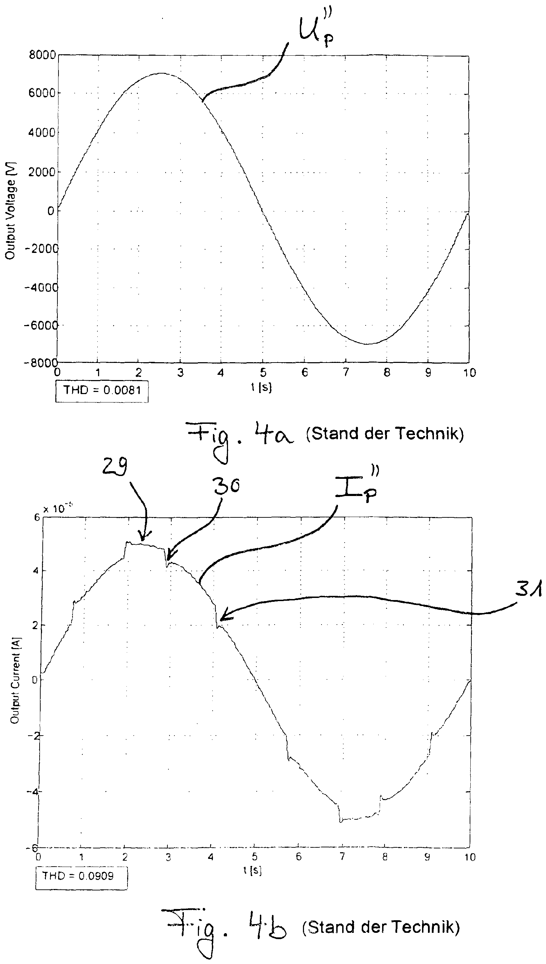

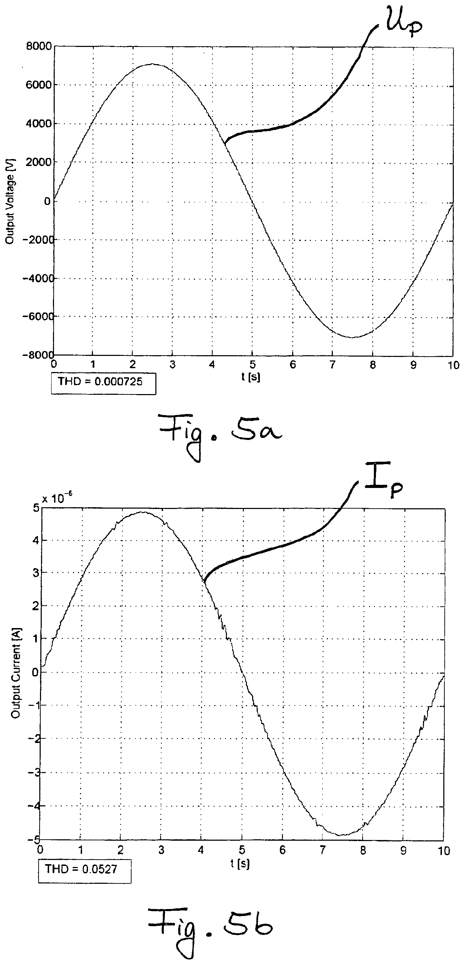

Die Fig. 4a, 4b und 5a, 5b zeigen schließlich noch reale Messergebnisse zu Vergleichsmessungen der Prüfspannung und des Prüfstroms bei einer Versuchsanordnung, bei der - bei ansonsten absolut baugleichen Geräten - zunächst eine aus dem Stand der Technik bekannte Schaltungsanordnung mit Rückregelung auf die Schaltnetzteile der beiden Verstärkerzweige verwendet wurde (siehe Fig. 4a und 4b) und sodann eine erfindungsgemäße Schaltungsanordnung gemäß Fig. 2 Verwendung fand (siehe Fig. 5a und 5b).

Der in Fig. 4a dargestellte Verlauf der Prüfspannung U_{P}", welcher mit einer aus dem Stand der Technik bekannten Schaltungsanordnung erzielt wurde, zeigt einen sinusförmigen Verlauf mit kaum erkennbaren Oberwellen, der einen den Oberwellenanteil repräsentierenden THD-Wert (gesamte harmonische Verzerrung) von 0,0081 aufweist. Demgegenüber sind in dem hierbei erzeugten und in Fig. 4b dargestellten Verlauf des Prüfstroms I_{P}" eine Vielzahl an Störungen 29, 30, 31 zu erkennen, die durch Regelungseingriffe auf die Hochspannungsquellen und einen Kanten aufweisenden Verlauf der Spannungsamplitude am Ausgang der beiden Hochspannungsquellen verursacht werden und zu einem THD-Wert für den Prüfstrom I_{P}" von 0,0909 führen.

Demgegenüber weisen die mit einer erfindungsgemäßen Schaltungsanordnung realisierten Verläufe der Prüfspannung U_{P} und des Prüfstroms I_{P} mit THD-Werten von 0,000725 für die Prüfspannung U_{P} (vgl. Fig. 5a) und von 0,0527 für den Prüfstrom I_{P} einen - im Vergleich zum Stand der Technik - jeweils nahezu oberwellenfreien Verlauf auf, was die Messgenauigkeit eines mit einer erfindungsgemäßen Schaltungsanordnung ausgestatteten Messgeräts deutlich verbessert.

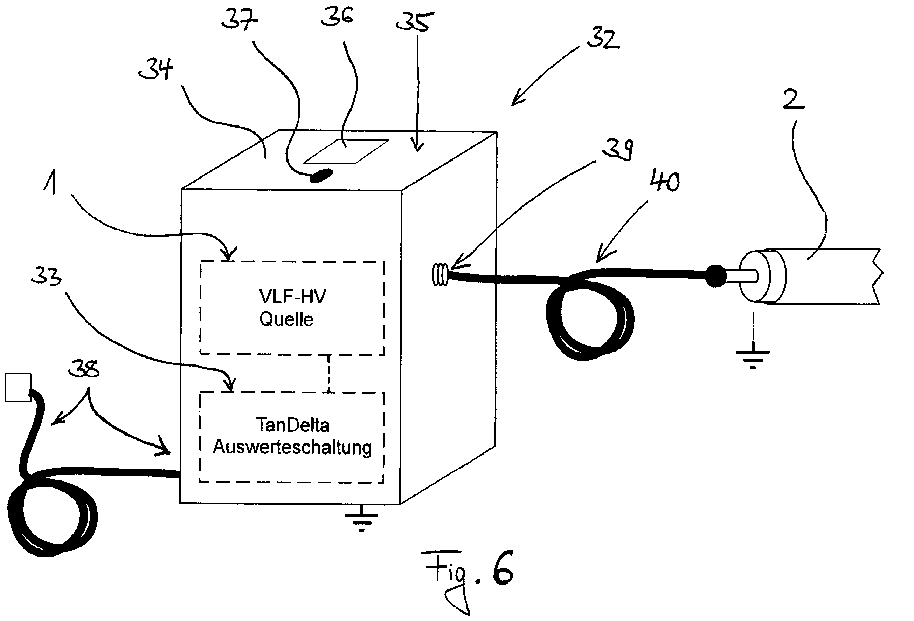

Fig. 6 zeigt schließlich noch ein erfindungsgemäßes Prüfgerät 32, welches, wie dies schematisch dargestellt ist, eine erfindungsgemäße Schaltungsanordnung 1 ("VLF-HV Quelle") zur Erzeugung einer geeigneten (VLF-) Prüfspannung und eine hiermit gekoppelte und in das Prüfgerät integrierte Mess- und Auswerteelektronik 33 ("Tan-Delta Auswerteschaltung") zur Ermittlung des Verlustfaktors des zu prüfenden Prüflings 2, vorliegend eines Hoch- oder Mittelspannungskabels 2, aufweist.

Dabei sind sowohl die Schaltungsanordnung 1 als auch die Mess-/Auswerteelektronik 33 innerhalb des Gehäuses 34 des Prüfgeräts 32 angeordnet, auf dessen Oberseite 35 vorliegend wenigstens ein Display / Anzeigeelement 36 zur Anzeige der gewonnen Prüfdaten und wenigstens ein Bedienelement 37 zur Einstellung der Messparameter vorgesehen ist, wie dies schematisch angedeutet ist.

Das Gerät weist ferner einen Anschluss 38 für die Netzspannung und einen Anschluss 39 für den - vorliegend über ein Hochspannungskabel 40 - anzuschließenden Prüfling 2 auf.

## Patentansprüche

1. Schaltungsanordnung (1) zur Erzeugung einer Prüfspannung (U_{P}) für die Prüfung eines Prüflings (2) umfassend
- zwei Hochspannungsquellen (3, 4) zur Erzeugung einer positiven und einer negativen Hochspannung (U₁, U₂) variabler Amplitude an ihren jeweiligen Ausgängen (5, 6),
- eine zwischen den Ausgängen (5, 6) der zwei Hochspannungsquellen (3, 4) und dem Prüfling (2) angeordnete Hochspannungsschalteranordnung (7), die zur sukzessiven Auf- und Entladung des Prüflings (2) geeignet schaltbar ist,
wobei ferner eine Regelung (8) vorgesehen ist, die die aktuelle Prüfspannung (U_{P}) am Prüfling (2) misst und abhängig von der gemessenen Prüfspannung (U_{P}) zur definierten Auf- und Entladung des Prüflings (2) auf die Hochspannungsschalteranordnung (7) einwirkt,
**dadurch gekennzeichnet,**
**dass** die Regelung (8) nicht auf die beiden Hochspannungsquellen (3, 4) einwirkt und
**dass** eine separate Steuerung (14) für die beiden Hochspannungsquellen (3, 4) vorgesehen ist, wobei die Steuerung (14) ein von der Spannung (U_{P}) am Prüfling (2) unabhängiges Taktsignal (T) erzeugt, so dass von den Hochspannungsquellen (3, 4) eine synchronisierte, vordefinierte und nicht durch die Regelung (8) beeinflusste Hochspannung (U₁, U₂) bereitgestellt wird.

2. Schaltungsanordnung nach Anspruch 1,
**dadurch gekennzeichnet,**
**dass** die Hochspannungsschalteranordnung (7) durch eine als spannungsgesteuerte Stromquelle fungierende Halbleiterschalteranordnung gebildet ist.

3. Schaltungsanordnung nach Anspruch 1 oder 2,
**dadurch gekennzeichnet,**
**dass** die zwei Hochspannungsquellen (3, 4) durch zwei Verstärkerzweige (18; 19) gebildet sind, die jeweils ein Schaltnetzteil (21; 22), einen Hochspannungstransformator (23; 24) und eine Gleichrichterschaltung (25; 26) aufweisen, wobei jeder Verstärkerzweig (18; 19) eingangsseitig mit einer Gleichrichterschaltung (20) verbunden ist, welche aus einer Netzspannung eine Gleichspannung erzeugt.

4. Schaltungsanordnung nach Anspruch 3,
**dadurch gekennzeichnet,**
**dass** die Schaltnetzteile (21, 22) zur Erzeugung einer sinusförmigen Wechselspannung eingerichtet sind, wobei der Phasenwinkel der sinusförmigen Wechselspannung durch das Taktsignal (T) vorgegeben wird.

5. Schaltungsanordnung nach Anspruch 4,
**dadurch gekennzeichnet,**
**dass** die Prüfspannung (U_{P}) und der sich hieraus ergebende Prüfstrom (I_{P}), mit welchem die definierte Auf- und Entladung des Prüflings (2) erfolgt, sinusförmig sind.

6. Schaltungsanordnung nach Anspruch 5,
**dadurch gekennzeichnet,**
**dass** die Prüfspannung (U_{P}) mit einer gesamten harmonischen Verzerrung (THD) von kleiner gleich 0,1 % nahezu oberwellenfrei ist.

7. Schaltungsanordnung nach Anspruch 5 oder 6,
**dadurch gekennzeichnet,**
**dass** der Prüfstrom (I_{P}) mit einer gesamten harmonischen Verzerrung von (THD) kleiner gleich 5 % nahezu oberwellenfrei ist.

8. Prüfgerät (32) enthaltend eine Schaltungsanordnung (1) nach einem der Ansprüche 1 - 7, einen Anschluss (38) für die Netzspannung und einen Anschluss (39) für den Prüfling (2),
**dadurch gekennzeichnet,**
**dass** das Prüfgerät (32) eine integrierte Mess- und Auswerteelektronik (33) zur Ermittlung des Verlustfaktors des Prüflings (2) aufweist.

9. Prüfgerät nach Anspruch 8,
**dadurch gekennzeichnet,**
**dass** das Prüfgerät (32) für die Ermittlung des Verlustfaktors eine Messgenauigkeit von +/- 1 ^{∗} 10⁻⁴ aufweist, und zwar bei einer Kapazität des Prüflings von nur 2 nF und über einen Prüfspannungsbereich von 3 kV bis 20 kV.

10. Prüfgerät nach einem der Ansprüche 8 oder 9,
**dadurch gekennzeichnet,**
**dass** der in der Mess- und Auswerteelektronik (32) gemessene Prüfstrom (I_{P}) über eine Schutzerdeverbindung oder über eine Guard-Verbindung geführt wird.

11. Verfahren zur Erzeugung einer Prüfspannung (U_{P}) für die Prüfung eines Prüflings (2) umfassend die folgenden Schritte:
(A) Erzeugung einer ersten Hochspannung (U₁) mit positivem Vorzeichen und variabler Amplitude am Ausgang einer ersten Hochspannungsquelle (3) und einer zweiten Hochspannung (U₂) mit negativem Vorzeichen und variabler Amplitude am Ausgang einer zweiten Hochspannungsquelle (4), und
(B) Sukzessives Auf- und Entladen des Prüflings (2) durch geeignete Schaltung einer zwischen den Ausgängen (5, 6) der Hochspannungsquellen (3, 4) und dem Prüfling (2) angeordneten Hochspannungsschalteranordnung (7), wobei eine Regelung (8) vorgesehen ist, die die Spannung (U_{P}) am Prüfling (2) misst und abhängig von der gemessenen Spannung (U_{P}) zur definierten Auf- und Entladung des Prüflings (2) auf die Hochspannungsschalteranordnung (7) einwirkt,
**dadurch gekennzeichnet,**
**dass** die Regelung (8) nicht auf die beiden Hochspannungsquellen (3, 4) einwirkt und
**dass** eine separate Steuerung (14) auf die beiden Hochspannungsquellen (3, 4) einwirkt, wobei die Steuerung (14) ein von der Spannung (U_{P}) am Prüfling (2) unabhängiges Taktsignal (T) erzeugt, so dass von den zwei Hochspannungsquellen (3, 4) eine synchronisierte, vordefinierte und nicht durch die Regelung (8) beeinflusste Hochspannung (U₁, U₂) bereitgestellt wird.

## Claims

1. A circuit arrangement (1) for generating a test voltage (U_{P}) for testing a test object (2) comprising :
- two high-voltage sources (3, 4) for generating a positive and a negative high voltage (U₁, U₂) of variable amplitude at their respective outputs (5, 6),
- a high-voltage switch arrangement (7), which is disposed between the outputs (5, 6) of the two high-voltage sources (3, 4) and the test object (2) and which can be switched appropriately for successive charging and discharging of the test object (2),
wherein a closed-loop controller (8) is further provided that measures the instantaneous test voltage (U_{P}) at the test object (2) and, as a function of the measured test voltage (U_{P}), acts on the high-voltage switch arrangement (7) for well-defined charging and discharging of the test object (2),
**characterized in that** the closed-loop controller (8) does not act on the two high-voltage sources (3, 4) and a separate open-loop controller (14) is provided for the two high-voltage sources (3, 4), wherein the open-loop controller (14) generates a clock signal (T) independent of the voltage (U_{P}) at the test object (2), so that a synchronized, predefined high voltage (U₁, U₂) uninfluenced by the closed-loop controller (8) is supplied by the high-voltage sources (3, 4).

2. The circuit arrangement of claim 1, **characterized in that** the high-voltage switch arrangement (7) is formed by a semiconductor switch arrangement acting as a voltage-controlled power source.

3. The circuit arrangement of claims 1 or 2, **characterized in that** the two high-voltage sources (3, 4) are formed by two amplifier branches (18; 19), which are each provided with a switched-mode power supply (21; 22), a high-voltage transformer (23; 24) and a rectifier circuit (25; 26), wherein each amplifier branch (18; 19) is connected on the input side to a rectifier circuit (20) that generates a d.c. voltage from a line voltage.

4. The circuit arrangement of claim 3, **characterized in that** the switched-mode power supplies (21, 22) are designed to generate a sinusoidal a.c. voltage, wherein the phase angle of the sinusoidal a.c. voltage is predetermined by the clock signal (T).

5. The circuit arrangement of claim 4, **characterized in that** the test voltage (U_{P}) and the test current (I_{P}) derived therefrom, with which the well-defined charging and discharging of the test object (2) take place, are sinusoidal.

6. The circuit arrangement of claim 5, **characterized in that** the test voltage (U_{P}), with a total harmonic distortion (THD) of smaller than or equal to 0.1%, is almost harmonics-free.

7. The circuit arrangement of claims 5 or 6, **characterized in that** the test current (Ip), with a total harmonic distortion (THD) of smaller than or equal to 5%, is almost harmonics-free.

8. A test instrument (32) that comprises the circuit arrangement (1) of claim 1, a port (38) for the line voltage and a port (39) for the test object (2), **characterized in that** the test instrument (32) is provided with integrated measuring and evaluation electronics (33) for determining the loss factor of the test object (2).

9. The test instrument of claim 8, **characterized in that** the test instrument (32) for determination of loss factor has a measurement accuracy of +/- 1 ^{∗} 10⁻⁴, and specifically for a capacitance of the test instrument of only 2 nF and over a test-voltage range of 3 kV to 20 kV.

10. The test instrument of one of claims 8 or 9, **characterized in that** the test current (I_{P}) measured in the measuring and evaluation electronics (32) is routed via a protective ground connection or via a guard connection.

11. A method for generating a test voltage (U_{P}) for testing a test object (2), comprising:
(A) Generating a first high voltage (U₁) with positive sign and variable amplitude at the output of a first high-voltage source (3) and a second high voltage (U₂) with negative sign and variable amplitude at the output of a second high-voltage source (4), and
(B) Successively charging and discharging the test object (2) by appropriate switching of a high-voltage switch arrangement (7) disposed between the outputs (5, 6) of the high-voltage sources (3, 4) and the test object (2), wherein a closed-loop controller (8) is provided that measures the voltage (U_{P}) at the test object (2) and, as a function of the measured voltage (U_{P}), acts on the high-voltage switch arrangement (7) for well-defined charging and discharging of the test object (2),
**characterized in that** the closed-loop controller (8) does not act on the two high-voltage sources (3, 4) and that a separate open-loop controller (14) acts on the two high-voltage sources (3, 4), wherein the open-loop controller (14) generates a clock signal (T) independent of the voltage (U_{P}) at the test object (2), so that a synchronized, predefined high voltage (U₁, U₂) uninfluenced by the closed-loop controller (8) is supplied by the two high-voltage sources (3, 4).

## Revendications

1. Configuration de circuit (1), destinée à générer une tension d'essai (U_{P}) pour tester un échantillon (2) comprenant
- deux sources de haute tension (3, 4), destinées à générer une haute tension (U₁, U₂) positive et négative d'amplitude variable sur ses sorties (5, 6) respectives,
- une configuration de commutateurs haute tension (7) placée entre les sorties (5, 6) des deux sources de haute tension (3, 4) et l'échantillon (2), qui est commutable de manière adaptée pour le chargement et le déchargement successifs de l'échantillon (2), étant prévue par ailleurs une régulation (8) qui mesure la tension d'essai (U_{P}) actuelle sur l'échantillon (2) et en fonction de la tension d'essai (U_{P}) mesurée, agit sur la configuration de commutateurs haute tension (7), pour le déchargement et le chargement de l'échantillon (2),
**caractérisée en ce que**
la régulation (8) n'agit pas sur les deux sources de haute tension (3, 4) et
**en ce qu'**il est prévu un système de commande (14) séparé pour les deux sources de haute tension (3, 4), le système de commande (14) générant un signal d'horloge (T) indépendant de la tension (U_{P}) sur l'échantillon (2), de sorte que par les sources de haute tension (3, 4) soit mise à disposition une haute tension (U₁, U₂) synchronisée, prédéfinie et non influencée par la régulation (8).

2. Configuration de circuit selon la revendication 1,
**caractérisée en ce que**
la configuration de commutateurs haute tension (7) est formée d'une configuration de commutateurs à semiconducteurs fonctionnant comme une source électrique commandée par tension.

3. Configuration de circuit selon la revendication 1 ou 2,
**caractérisée en ce que**
les deux sources de haute tension (3, 4) sont formées de deux branches d'amplificateurs (18; 19) qui comportent chacun un bloc d'alimentation (21; 22), un transformateur haute tension (23; 24) et un circuit redresseur (25; 26), chaque branche d'amplificateur (18; 19) étant connectée du côté entrée avec un circuit redresseur (20), qui à partir d'une tension de réseau génère une tension continue.

4. Configuration de circuit selon la revendication 3,
**caractérisée en ce que**
les blocs d'alimentation (21, 22) sont aménagés pour générer une tension alternative sinusoïdale, l'angle de phase de la tension alternative sinusoïdale étant prédéfini par le signal d'horloge (T).

5. Configuration de circuit selon la revendication 4,
**caractérisée en ce que**
la tension d'essai (U_{P}) et le courant d'essai (I_{P}) qui en résulte, à l'aide duquel s'effectue le chargement et le déchargement prédéfinis de l'échantillon (2) sont de forme sinusoïdale.

6. Configuration de circuit selon la revendication 5,
**caractérisée en ce que**
la tension d'essai (U_{P}) avec une distorsion harmonique totale (THD) inférieure ou égale à 0,1 % est quasiment exempte d'harmoniques.

7. Configuration de circuit selon la revendication 5 ou 6,
**caractérisée en ce que**
le courant d'essai (I_{P}) avec une distorsion harmonique totale de (THD) inférieure ou égale à 5 % est quasiment exempte d'harmoniques.

8. Instrument d'essai (32), contenant une configuration de circuit (1) selon l'une quelconque des revendications 1 à 7, un branchement (38) pour la tension de réseau et un branchement (39) pour l'échantillon (2),
**caractérisée en ce que**
l'instrument d'essai (32) comporte une électronique de mesure et d'évaluation (33) intégrée, destiné à déterminer le coefficient de perte de l'échantillon (2).

9. Instrument d'essai selon la revendication 8,
**caractérisée en ce que**
pour la détermination du coefficient de perte, l'instrument d'essai (32) fait preuve d'une précision de mesure de +/- 1 ^{∗} 10⁻⁴, à savoir pour une capacité de l'échantillon de seulement 2 nF et sur une plage de tension d'essai de 3 kV à 20 kV.

10. Instrument d'essai selon l'une quelconque des revendications 8 ou 9,
**caractérisée en ce que**
le courant d'essai (I_{P}) mesuré dans l'électronique de mesure et d'évaluation (32) est conduit via une connexion de mise à la terre ou via une connexion de garde.

11. Procédé, destiné à générer une tension d'essai (U_{P}) pour tester un échantillon (2), comprenant les étapes suivantes, consistant à :
(A) générer une première haute tension (U₁) à signe algébrique positif et amplitude variable à la sortie d'une première source de haute tension (3) et une deuxième haute tension (U₂) à signe algébrique négatif et amplitude variable à la sortie d'une deuxième source de haute tension (4), et
(B) charger et décharger successivement l'échantillon (2) par commutation adaptée d'une configuration de commutateurs haute tension (7) placée entre les sorties (5, 6) des sources de haute tension (3, 4) et l'échantillon (2), une régulation (8) étant prévue, qui mesure la tension (U_{P}) sur l'échantillon (2) et qui en fonction de la tension (U_{P}) mesurée, agit sur la configuration de commutateurs haute tension (7), pour le chargement et le déchargement défini de l'échantillon (2),
**caractérisé**
**en ce que** la régulation (8) n'agit pas sur les deux sources de haute tension (3, 4) et
**en ce qu'**un système de commande (14) séparé agit sur les deux sources de haute tension (3, 4), le système de commande (14) générant un signal d'horloge (T) indépendant de la tension (U_{P}) sur l'échantillon (2), de telle sorte que par les deux sources de haute tension (3, 4) soit mise à disposition une haute tension (U₁, U₂) synchronisée, prédéfinie et non influencée par la régulation (8).
